# EUROPEAN PATENT APPLICATION

(11) **EP 4 625 415 A1**
(43) Date of publication of application: **01.10.2025**
(21) Application number: 24167188.2
(22) Date of filing: 28.03.2024
(51) Int. Cl.: G11C 11/22

(54) **A METHOD AND A MEMORY DEVICE FOR SYMMETRIC NON-DESTRUCTIVE READ-OUT OF A FERROELECTRIC MEMORY CELL**

(71) Applicant: IMEC vzw, 3001 Leuven (BE)
(72) Inventor: Hellings, Geert, 1500 Halle (BE); Xiang, Yang, 3001 Heverlee (BE); Van Houdt, Jan, 3460 Bekkevoort (BE)
(74) Representative: Roth, Sebastian

(57) **Abstract**

The present disclosure provides a ferroelectric memory device, which includes a memory cell with a ferroelectric capacitor, and a charge sensor connected to the memory cell. The disclosure provides a method for non-destructively reading out the memory cell. The method comprises applying a voltage to the capacitor plates of the ferroelectric capacitor, via voltage lines, wherein a value of the voltage is always lower than a voltage value required to change a current polarization state of the ferroelectric capacitor. The method comprises sensing and summing a charge coming out of the ferroelectric capacitor via one of the voltage lines during four sensing phases. Thereby, the voltage value is changed over the four sensing phases in a symmetric manner. The resulting charge on the voltage line is sensed by the charge sensor, and is summed with different signs for a first and third sensing phase of the four sensing phases one the one hand, and a second and fourth sensing phase on the other hand.

## Description

### TECHNICAL FIELD

The present disclosure relates to the field of capacitor-based ferroelectric memory devices. In particular, the present disclosure relates to a memory device, which includes a ferroelectric memory cell and a charge sensor connected to the memory cell. The disclosure also relates to a method for non-destructively reading out the ferroelectric memory cell of the memory device.

### BACKGROUND

A ferroelectric memory cell stores data in a non-volatile manner using different polarization states (e.g. "up", "down") of a ferroelectric material. A memory device typically comprises an array of such memory cells, wherein each memory cell comprises a ferroelectric capacitor and a select transistor (so-called 1T-1C memory configuration). The ferroelectric material is arranged between the two capacitor plates of the ferroelectric capacitor, and the polarization state of the ferroelectric material defines the memory state of the memory cell.

To read out the memory state, the memory cell may be forced to a known memory state, i.e., to a particular net polarization state of the ferroelectric material. Based on the response of the memory cell, it can then be deduced whether the memory state has changed as a result or not. In particular, depending on the memory state of the ferroelectric capacitor, a small charge displacement can be measured ("Read 1") or a bigger charge displacement can be measured ("Read 0").

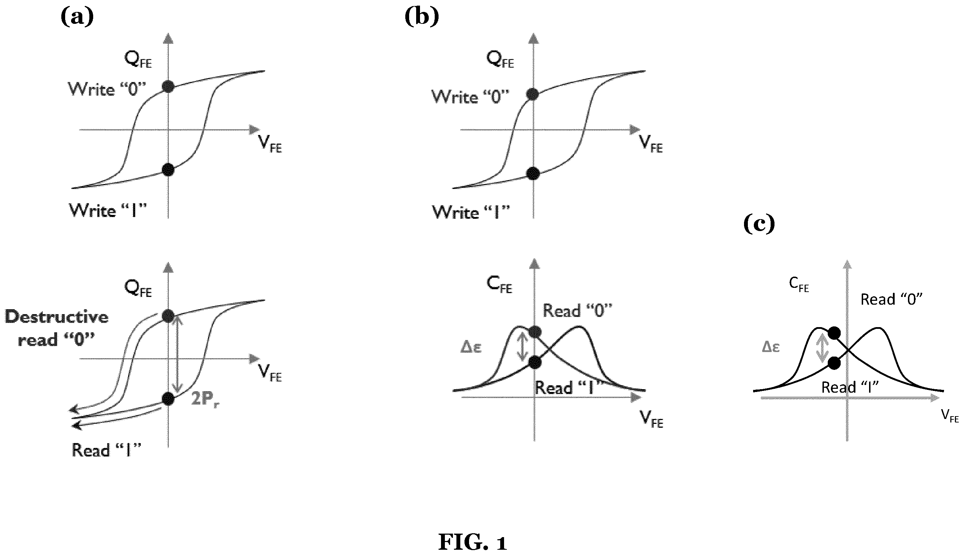

This read operation is destructive in the sense that it brings the ferroelectric capacitor to a known memory state (e.g., a logical 1). The information that was held is now destroyed by the read operation. In 50% of the cases (on average) the current memory state of the memory cell is overwritten in this way during the read-out, and the memory cell needs to be reprogrammed afterwards. This read-out scheme is thus a so-called destructive read-out, and is illustrated in FIG. 1(a). The lower diagram in FIG. 1(a) illustrates the destructive read-out, and the upper diagram illustrates the write.

In case of the destructive read-out, the endurance of the memory cell, i.e., the total number of attainable write/erase cycles, is limited and linked to the number of read cycles. In addition, since the destructive read-out requires a voltage that is sufficiently high to switch the memory cell to a known memory state, and since the memory cells also need to be rewritten in 50% of the cases, the power consumption of the memory device is high.

Moreover, the select transistors, which are used for decoding of memory cells of the memory device in the 1T-1C configuration, enhance the size of the memory cells, and make the memory cells more or less un-stackable, especially when using silicon transistors.

Overall, an improved memory device and a new scheme for reading-out ferroelectric memory cells is thus desired.

### SUMMARY

The present disclosure and its solutions are further based on the following considerations.

In an alternative read-out scheme, the memory cells are read out in a non-destructive manner. To this end, for example, different work function metals can be used for building the capacitor plates of the ferroelectric capacitor. This causes an asymmetry of a hysteresis loop of the ferroelectric material of the ferroelectric capacitor, and particularly also an asymmetry of the capacitance-voltage hysteresis. Due to this asymmetry, a capacitance, and therefore also a dielectric response of the ferroelectric capacitor, differs depending on the current polarization state of the ferroelectric material, even if no bias voltage is applied to the ferroelectric capacitor. This difference in capacitance (or dielectric response) is referred to as a memory window. Using this memory window, the current polarization state of the ferroelectric material can be detected by measuring a dielectric response (e.g., an effective permittivity or capacitance) of the ferroelectric material, even if no (or only a small) bias voltage is applied. Hence, the memory state of the memory cell can be read-out without having to "switch" the polarization state of the ferroelectric material of the memory cell. This non-destructive read-out scheme employing asymmetric work function metals is illustrated in FIG. 1(b). The lower diagram in FIG. 1(b) illustrates the non-destructive read-out, and the upper diagram illustrates the write.

Alternatively, it is also possible to perform a non-destructive readout using symmetric work function metals for building the capacitor plates of the ferroelectric capacitor. Symmetric work function metals provide a symmetric window around oV. For example, applying a voltage (lower than a voltage required to change a current polarization state of the ferroelectric capacitor) may allow distinguishing between the capacitance values of the polarization states. Such a non-destructive read is shown in FIG. 1(c).

The non-destructive read-out can be exploited, for example, to build a 0T-1C memory array, wherein the memory cells do not have a select transistor each, but comprise only the ferroelectric capacitor. A memory device based on a ferroelectric selector-less array and a non-destructive read-out scheme would offer many advantages. For example, a reliability of the memory device could be improved, because the need for a re-write after a read of a memory cell can be eliminated. Further, without select transistor per memory cell, a higher memory density and facilitated 3D stacking of memory cells can be achieved.

However, when using the non-destructive read-out for a memory cell with the 0T-1C configuration, a very small signal has to be detected. This is because the difference between the two capacitance states of the ferroelectric capacitor is small, and also because a read voltage applied to the ferroelectric capacitor is small.

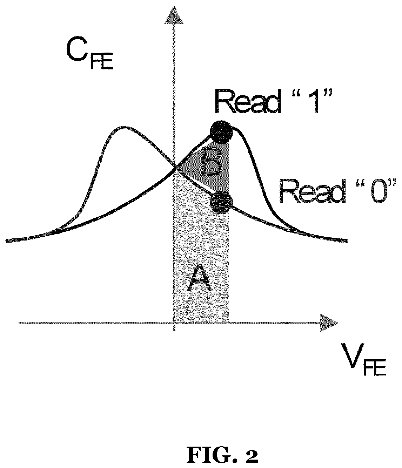

In particular, as illustrated in FIG. 2, measuring a ferroelectric capacitor and determining whether its dielectric permittivity is in a high or a low state is quite difficult, because the signal difference between both is very small. For example, for a ferroelectric capacitor having a capacitance of 2fC and a 10% ferroelectric effect (i.e., Δε ≈10%), the signal would be only 5%, i.e., either charge A or charge A+B. In particular, a Read "1" would give charge Q_{A}+Q_{B}, wherein charge Q_{B} is about 20 times smaller than charge Q_{A}. A Read "0" gives charge Q_{A}. It would, for example, be very hard to measure the difference with a sense amplifier connected via a voltage line to the ferroelectric capacitor, if, e.g. a bit line voltage (V_{BL}) is 100 mV for Read "0" and 105 mV for Read "1". Such small signals are especially difficult to measure, if not impossible, in the presence of variability of the capacitance of the ferroelectric capacitor, the capacitance of the bit line to which the ferroelectric capacitor is connected, and of the sensing elements used.

An objective of this disclosure is to solve the above-mentioned issues. That is, an objective is to provide a memory device including ferroelectric memory cells, which can be read out reliably using non-destructive read. An objective is to provide an improved non-destructive read-out scheme, so as to ensure the reliability of the non-destructive read even in the presence of the above-mentioned variabilities.

These and other objectives are achieved by the solutions of this disclosure described in the independent claims. Advantageous implementations are described in the dependent claims.

A first aspect of this disclosure provides a method for reading out a memory cell of a ferroelectric memory device, wherein the memory cell comprises a ferroelectric capacitor, wherein a first capacitor plate of the ferroelectric capacitor is connected to a first voltage line, and a second capacitor plate of the ferroelectric capacitor is connected to a second voltage line; wherein the method comprises: applying a voltage to the ferroelectric capacitor plates of the ferroelectric capacitor via the voltage lines, wherein a value of the voltage is always lower than a voltage value required to change a current polarization state of the ferroelectric capacitor; and sensing and summing charge on the first voltage line during four sensing phases; wherein during a first sensing phase of the four sensing phases, the applied voltage is raised from a first value to a second value; wherein during a second sensing phase of the four sensing phases, the applied voltage is lowered from the second value to the first value; wherein during a third sensing phase of the four sensing phases, the applied voltage is lowered from the first value to a third value; wherein during a fourth sensing phase of the four sensing phases, the applied voltage is raised from the third value to the first value; wherein the first value is the midpoint between the second value and the third value; and wherein the sign of the charge, which is sensed during the second and the fourth sensing phase, respectively, is reversed before the summing.

With the method of the first aspect, the memory cell can be read out non-destructively. The memory cell can also be read-out reliably, due to the charge summing over the four sensing phases, even in the presence of variabilities of the involved capacitances. With the charge summing during the four sensing phases, the problem of the small relative difference between the two capacitance states of the memory cell can be mitigated.

In an implementation of the method, when summing the charge on the first voltage line during the four sensing phases, the charge sensed during the first and the third sensing phase is multiplied, respectively, by +1, and the charge sensed during the second and the fourth sensing phase is multiplied, respectively, by -1.

In this way, the charge can be integrated during the four sensing phases in a manner that leads to a larger signal, which can be reliably read.

In an implementation of the method, the first value of the voltage is zero, and the second value and the third value have the same absolute value but different signs.

In an implementation of the method, the absolute value of the second value and the third value of the voltage is respectively in a range of 0.1-1 V.

In an implementation of the method, multiple repetitions of the four sensing phases are performed.

In this way, even more charge can be integrated, and the read-out signal becomes even more reliably.

In an implementation of the method for two consecutive repetitions of the four sensing phases, the sequence of the four sensing phases is reversed.

In an implementation of the method, for two consecutive repetitions of the four sensing phases, for the first repetition the sequence is first, then second, then third, then fourth sensing phase, while for the second repetition the sequence is fourth, then third, then second, then first sensing phase.

In this way, the method is immune to a time delay between the applied voltage and a sensed charge (e.g., caused by a resistance of the first voltage line).

A second aspect of this disclosure provides a ferroelectric memory device comprising a memory cell including a ferroelectric capacitor; a first voltage line connected to a first capacitor plate of the ferroelectric capacitor; a second voltage line connected to a second capacitor plate of the ferroelectric capacitor; a charge sensor connected to the first voltage line and configured to sense and sum charge on the first voltage line; a voltage source configured to apply a voltage to the ferroelectric capacitor plates of the ferroelectric capacitor via the voltage lines, wherein a value of the voltage is always lower than a voltage value required to change a current polarization state of the ferroelectric capacitor; and a memory controller; wherein for reading out the memory cell, the memory controller (45) is configured to control the voltage source and the charge sensor, respectively, to: raise the applied voltage from a first value to a second value during a first sensing phase; lower the applied voltage from the second value to the first value during a second sensing phase; lower the applied voltage from the first value to a third value during a third sensing phase; raise the applied voltage from the third value to the first value during a fourth sensing phase; wherein the first value is the midpoint between the second value and the third value; and sense and sum the charge on the first voltage line during the four sensing phase, wherein the sign of the charge, which is sensed during the second and the fourth sensing phase, respectively, is reversed before the summing.

The memory device of the second aspect achieves the same advantages as the method of the first aspect, and may be extended by respective implementations as described above for the method of the first aspect.

In an implementation of the ferroelectric memory device, the first voltage line is a bit line, and the second voltage line is a word line or is connected to a word line of the ferroelectric memory device.

In an implementation, the ferroelectric memory device comprises: a plurality of memory cells, wherein each of the memory cells comprises a ferroelectric capacitor, and wherein the memory cells are arranged in an array comprising rows and columns; a plurality of bit lines comprising the first voltage line, wherein each of the bit lines is connected to the memory cells of one column: a plurality of word lines comprising the second voltage line, wherein each of the word lines is connected to the memory cells of one row; wherein each memory cell is connected to one of the bit lines and to one of the word lines; a plurality of charge sensors, wherein each bit line is connected to one charge sensor; wherein the memory controller is configured to, in order to read out a particular memory cell of the array: control the voltage source to apply the voltage to the ferroelectric capacitor plates of the ferroelectric capacitor of the particular memory cell, and to change the voltage from the first value to the second value, then from the second value to the first value, then from the first value to the third value, and then from the third value to the first value during, respectively, the four sensing phases; and control the charge sensor associated with the particular memory cell to sense and sum the charge on the bit line connected to the particular memory cell during the four sensing phases, wherein the sign of the charge, which is sensed during the second and the fourth sensing phase, respectively, is reversed before the summing.

Thus, the method of the first aspect, which may be implemented by the memory controller of the memory device of the second aspect, may be used to read out any memory cell in the memory array of the memory device.

In an implementation, the ferroelectric capacitor comprises a ferroelectric material arranged between the first and the second capacitor plate, and wherein the first and the second capacitor plate are metallic and have the same work function.

In an implementation of the ferroelectric memory device, the ferroelectric material comprises hafnium-zirconium oxide, HZO, or doped HZO.

For example, the doped HZO may be lanthanum-doped HZO (HZO:La).

In an implementation of the ferroelectric memory device, the ferroelectric capacitor comprises a C-V curve that is symmetric around the first value of the voltage, for instance, around zero voltage.

Accordingly, also an ε-V curve of the ferroelectric capacitor is symmetric around the first value of the voltage, particularly, zero voltage.

A third aspect of this disclosure provides a memory controller for controlling a ferroelectric memory device, wherein, in order to control the read out of a memory cell of the ferroelectric memory device, the memory controller is configured to perform the method of the first aspect or any implementation thereof.

A fourth aspect of this disclosure provides a computer program comprising instructions which, when the program is executed by the memory controller of the third aspect, causes the memory controller to perform the method of the first aspect or any implementation thereof.

The memory controller of the third aspect and the computer program of the fourth aspect respectively achieve the same advantages as described for the method of the first aspect.

In summary of the above, this disclosure proposes a method and memory device with charge sensor, which allow integrating the charge coming out of the ferroelectric capacitor of a memory cell, but with a different sign depending on the four sensing phases of the voltage over the ferroelectric capacitor.

### BRIEF DESCRIPTION OF THE DRAWINGS

The above described aspects and implementations are explained in the following description of embodiments with respect to the enclosed drawings:
- FIG. 1: shows a comparison between (a) a destructive read-out scheme, and (b), (c) different non-destructive read-out schemes.
- FIG. 2: shows a non-destructive read-out scheme with symmetric work function metals and measurable charge.
- FIG. 3: shows a flow-diagram of a method for reading out a ferroelectric memory cell according to this disclosure.
- FIG. 4: shows (a) a memory device according to this disclosure, and (b) an illustration of the principles of the non-destructive read-out scheme proposed by this disclosure.
- FIG. 5: illustrates an exemplary non-destructive read-out scheme proposed by this disclosure.
- FIG. 6: illustrates multiple repetitions (cycles) of the read-out scheme proposed by this disclosure.
- FIG. 7: shows a memory array of a ferroelectric memory device according to this disclosure.

### DETAILED DESCRIPTION OF EMBODIMENTS

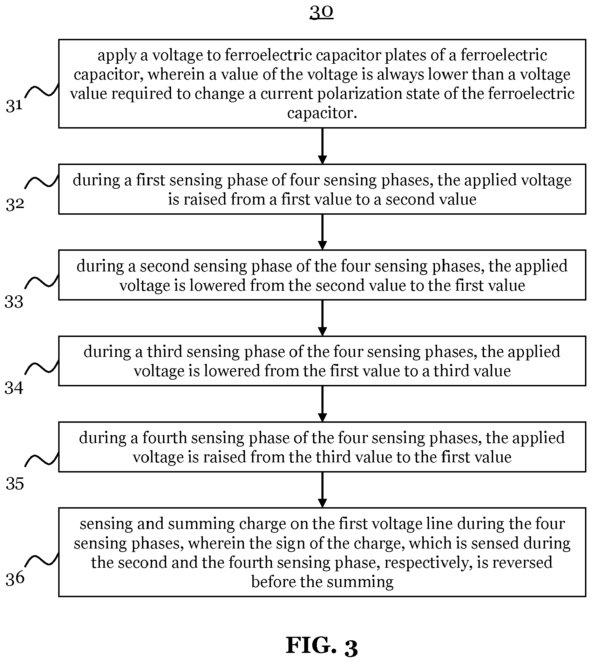

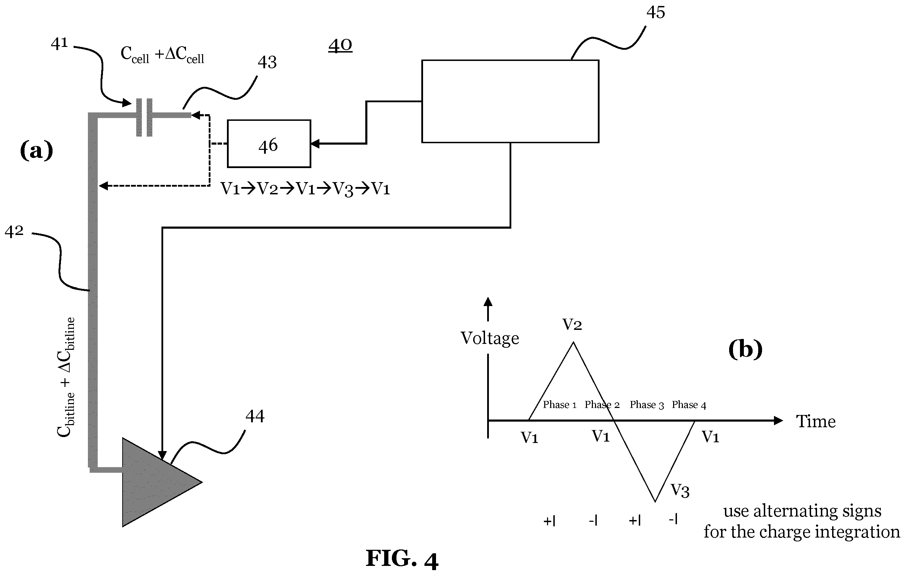

FIG. 3 shows a flow-diagram of a method 30 according to this disclosure. The method 30 is for reading out a memory cell of a ferroelectric memory device 40. FIG. 4(a) shows an example of such a ferroelectric memory device 40 according to this disclosure. The memory cell of the memory device 40 comprises a ferroelectric capacitor 41, a first voltage line 42, and a second voltage line 43. A first capacitor plate of the ferroelectric capacitor 41 is connected to the first voltage line 42, and a second capacitor plate of the ferroelectric capacitor 41 is connected to the second voltage line 43. Accordingly, in this example, the memory cell of the memory device 40 has a 0T-1C configuration. The memory device 40 can have multiple such memory cells, for instance, arranged in a 0T-1C memory array.

The first and the second capacitor plate of the ferroelectric capacitor 41 may respectively be made of a metal or a metal combination, which have the same or different work function(s). Preferably, both capacitor plates are made of the same work function metal. The first and second capacitor plate may respectively comprise one or more of: molybdenum; a composition comprising molybdenum and a molybdenum oxide; titanium nitride; a composition comprising ruthenium and titanium nitride; and tungsten. The first and second capacitor plate can either or both be selected from this list of materials or material combinations. The first and the second capacitor plate may comprise different materials or material combinations, or the same materials or material combinations.

A ferroelectric material, like hafnium-zirconium oxide (HZO), for example, lanthanum doped HZO (La:HZO), may be arranged between the two capacitor plates of the ferroelectric capacitor 41. However, other suitable ferroelectric materials known in the art may be used. In any case, the ferroelectric material is electrically excitable to two polarization states (e.g., "up" and "down"), wherein each polarization state represents a memory state (e.g. "1" and "0") of the memory cell of the memory device 40.

As shown further in FIG. 3, the method 30 then generally comprises applying 31 a voltage to the ferroelectric capacitor plates of the ferroelectric capacitor 41 via the voltage lines 42, 43. Thereby, a value of the applied voltage is always lower than a voltage value, which is required to change the (current) polarization state of the ferroelectric material of the ferroelectric capacitor 41. As illustrated in FIG. 4(a), the memory device 40 may, to this end, further comprise a voltage source 46, which is configured to apply the voltage to the ferroelectric capacitor plates of the ferroelectric capacitor 41. The voltage is applied to the ferroelectric capacitor 41 during at least four sensing phases.

As shown in FIG. 3, and also illustrated in FIG. 4(b), during a first sensing phase of the four sensing phases, the applied voltage is raised 32 from a first value V1 to a second value V2. Then, during a second sensing phase of the four sensing phases, the applied voltage is lowered 33 from the second value V2 to the first value V1. Then, during a third sensing phase of the four sensing phases, the applied voltage is lowered 34 from the first value V1 to a third value V3. Then, during a fourth sensing phase of the four sensing phases, the applied voltage is raised 35 from the third value V3 to the first value V1. The first value V1 may be the midpoint between the second value V2 and the third value V3. For example, the first value V1 of the voltage is zero, and the second value V2 and the third value V3 can have the same absolute value, but different signs (that is V2=-V3). For example, the absolute value of the second value V2 and the third value V3 of the voltage may respectively be in a range of 0.1-1 V. The voltage may be raised and/or lowered linearly, as illustrated in FIG. 4(b), however, this is not a must.

The method 30 also comprises a step 36 of sensing and summing charge on the first voltage line 42 during the four sensing phases. Notably, this step 36 is shown in FIG. 3 after the steps 32-35 of changing the applied voltage during the four sensing phases, but typically these steps happen in parallel. As shown in FIG. 4(a), the memory device 40 may, to this end, further comprises a charge sensor 44, for example a sense amplifier, which is connected to the first voltage line 42, and is configured to sense and sum the charge on the first voltage line 42.

The charge sensor 44 is in particular configured to integrate the charge, which it sees at its input, with different signs depending on the four sensing phases of the voltage applied over the ferroelectric capacitor 41. The sign of the charge, which is sensed during the second sensing phase and the fourth sensing phase, respectively, is reversed before the summing. For example, as illustrated in FIG. 4(b), the charge that is sensed during the first sensing phase and the third sensing phase is respectively multiplied by +1 for the summing, while the charge sensed during the second sensing phase and the fourth sensing phase is respectively multiplied by -1 ("reversed") for the summing.

As further shown in FIG. 4(a), the memory device 40 may comprise a memory controller 45, for example, a computer, a chip, or a processor, which - in order to control the read-out of the memory cell of the ferroelectric memory device 40 - is configured to control the voltage source 46 and the charge sensor 44 to implement the method 30 shown in FIG. 3.

The method 30 and the memory device 40 proposed in this disclosure have the advantage that the non-destructive read-out of the memory cell is insensitive to the capacitances C_{cell} of the memory cell and C_{bitline} of the first voltage line 42 (which may be a bit line), and particularly is insensitive to their respective variabilities ΔC_{cell} and ΔC_{bitline}. The four sensing phases further enlarge the net signal seen from the ferroelectric capacitor 41, and may even be repeated one or more times for an even stronger effect.

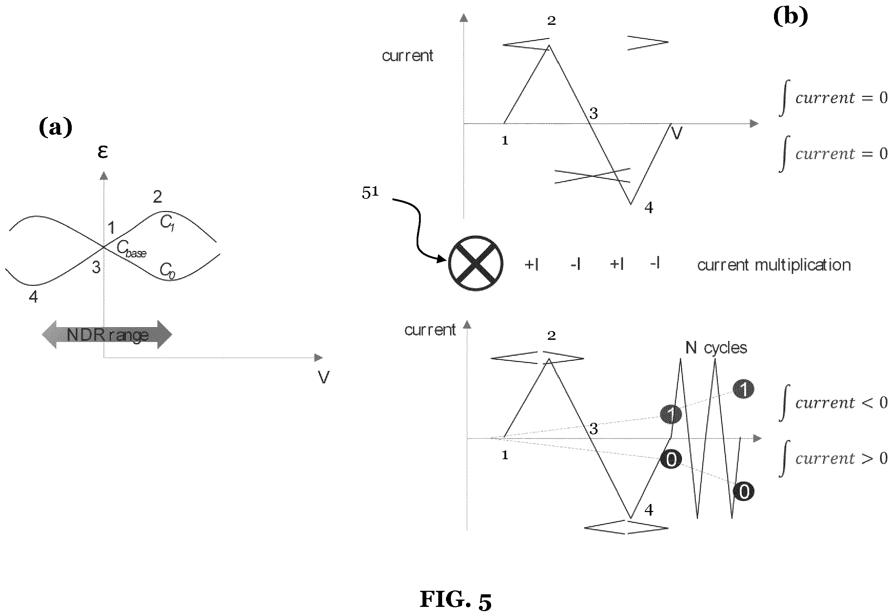

FIG. 5 illustrates again an exemplary read-out scheme proposed by this disclosure. FIG. 5(a) illustrates that the ferroelectric capacitor 41 may comprise a C-V curve that is symmetric around the first value V1 of the voltage, which may particularly be zero voltage (0V). The capacitance may change when applying the voltage with changing value during the four sensing phases, particularly from a base capacitance C_{base} at 0V (states 1 and 3) to a higher capacitance C₁ at V2 (state 2) and to a lower capacitance C₀ at V3 (state 4). The change of the voltage value is within the non-destructive read-out (NDR) range, wherein the voltage value is always smaller than a voltage value required to switch the polarization state of the ferroelectric material of the ferroelectric capacitor 41. Notably, FIG. 5(a) shows the permittivity ε on the y-axis and the voltage on the x-axis, however, the capacitance of the ferroelectric capacitor 41 is proportional to the permittivity according to C = εA/d, wherein d is the distance between the two capacitor plates and A is the parallel capacitor plate area.

FIG. 5 (b) illustrates a resulting signal after the four sensing phases, and after the summing with the reversed charge in the second sensing phase and the fourth sensing phase. The four capacitance states 1-4 of FIG. 5(a) are indicated in FIG. 5(b). In particular, the upper diagram of FIG. 5(b) shows that if no such charge reversing would be carried out, the net signal (represented by current integrated over the four sensing phases) would be zero. However, the lower diagram shows that if the multiplication 51 with +1 and -1 respectively is implemented, the net signal becomes non-zero. Notably, the four sensing phases can be performed one or more times in respectively one or more cycles, wherein N is the number of cycles, and N≥1.

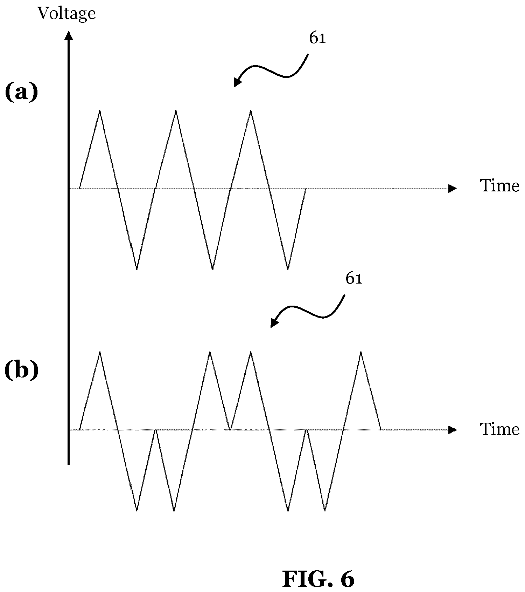

FIG. 6 illustrates two possibilities for performing such multiple repetitions 61 (cycles) of the four sensing phases and the method 30. In each case of FIG. 6(a) and 6(b), N repetitions 61 of the four sensing phases can be performed.

In FIG. 6(a), the four sensing phases are simply repeated in the same order for each repetition 61. In FIG. 6(b), however, for two consecutive repetitions 61 of the four sensing phases, the sequence of the four sensing phases is reversed. For instance, for two consecutive repetitions 61 of the four sensing phases, for the first repetition 61 the sequence is first sensing phase, then second sensing phase, then third sensing phase, then fourth sensing phase, while for the second repetition 61 the sequence is fourth sensing phase, then third sensing phase, then second sensing phase, then first sensing phase. That is, this implementation involves mirroring the four sensing phases. Notably, in each of these sensing phases, of course the voltage value is changed as described above, and the charge on the first voltage line 42 is sensed and summed as described above. The implementation of FIG. 6(b) is additionally immune to a time delay between the applied voltage and the charge seen at the input of the charge sensor 44, e.g., caused by the resistance of the first voltage line 42.

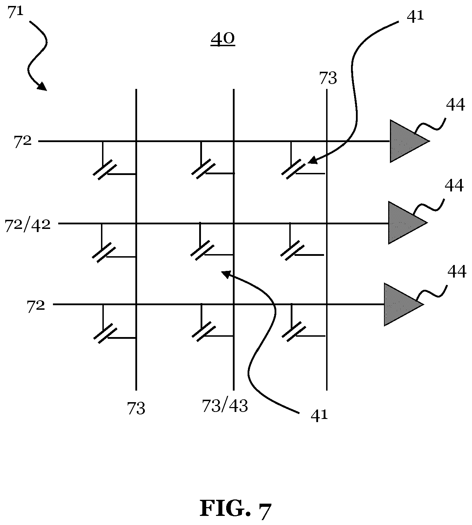

FIG. 7 shows an example of a memory array 71 of the ferroelectric memory device 40 according to this disclosure. The memory device 40 comprises a plurality of memory cells, wherein each of the memory cells comprises a ferroelectric capacitor 41 - like the memory cell described with respect to FIG. 4. The memory cells are arranged in rows and columns in the memory array 71. The memory array 71 may be a cross-bar memory array. The memory array 71 comprises a plurality of bit lines 72 and a plurality of word lines 73. Thereby, the first voltage line 42 shown in FIG. 4(a) is a bit line 72, and the second voltage line 43 shown in FIG. 4(a) is a word line. The array 71 has a 0T-1C configuration, which reduces the footprint of each cell and thus can scale down the memory array 71. Each bit line 72 is connected to the memory cells of one column, and each word line 73 is connected to the memory cells of one row. Each memory cell - particularly each ferroelectric capacitor 41 with its respective two capacitor plates - is thereby connected to one bit line 72 and to one word line 73.

The memory device 40 also comprises a plurality of charge sensors 44, for example, a plurality of sense amplifiers. Each bit line 72 is connected to one charge sensor 44, which is configured to sense charge on said bit line 72.

The memory controller 45 of the memory device 40 is configured to, in order to read out any particular memory cell of the memory array 71, cause the voltage to be applied to the ferroelectric capacitor plates of the ferroelectric capacitor 41 of the particular memory cell, and to control a change of the voltage from the first value V1 to the second value V2, then from the second value V2 to the first value V1, then from the first value V1 to the third value V3, and then from the third value V3 to the first value V1 during, respectively, the four sensing phases. This works as described above with respect to FIG. 3 and FIG. 4, and may be repeated N times. If another memory cell is to be read-out, the same procedure can be performed with a respective different ferroelectric capacitor 41 and charge sensor 44.

The memory controller 45 is thereby configured to control the charge sensor 44 associated with the particular memory cell, which is to be read out, in order to sense and sum the charge on the bit line 72 connected to said particular memory cell during the four sensing phases. As already described above, the sign of the charge, which is sensed during the second sensing phase and the fourth sensing phase, respectively, is thereby reversed before the summing in comparison with the charge sensed during the first sensing phase and the third sensing phase.

The memory controller 45 may comprise processing circuitry configured to perform, conduct or initiate various operations described in this disclosure. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The memory controller 45 may respectively further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the various operations of the memory controller 45 to be performed. In an example, the processing circuitry comprises one or more processing cores and a non-transitory memory connected to the one or more processing cores. The non-transitory memory may carry executable program code which, when executed by the one or more processing cores, causes the memory controller 45 to perform, conduct or initiate the operations or methods described in this disclosure.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A method (30) for reading out a memory cell of a ferroelectric memory device (40),
wherein the memory cell comprises a ferroelectric capacitor (41), wherein a first capacitor plate of the ferroelectric capacitor (41) is connected to a first voltage line (42), and a second capacitor plate of the ferroelectric capacitor (41) is connected to a second voltage line (43);
wherein the method (30) comprises:
applying (31) a voltage to the ferroelectric capacitor plates of the ferroelectric capacitor (41) via the voltage lines (42, 43) , wherein a value of the voltage is always lower than a voltage value required to change a current polarization state of the ferroelectric capacitor (41); and
sensing and summing (35) charge on the first voltage line (42) during four sensing phases;
wherein during a first sensing phase of the four sensing phases, the applied voltage is raised from a first value (V1) to a second value (V2);
wherein during a second sensing phase of the four sensing phases, the applied voltage is lowered from the second value (V2) to the first value (V1);
wherein during a third sensing phase of the four sensing phases, the applied voltage is lowered from the first value (V1) to a third value (V3);
wherein during a fourth sensing phase of the four sensing phases, the applied voltage is raised from the third value (V3) to the first value (V1);
wherein the first value (V1) is the midpoint between the second value (V2) and the third value (V3); and
wherein the sign of the charge, which is sensed during the second and the fourth sensing phase, respectively, is reversed before the summing.

2. The method (30) of claim 1, wherein, when summing (35) the charge on the first voltage line (42) during the four sensing phases, the charge sensed during the first and the third sensing phase is multiplied, respectively, by +1, and the charge sensed during the second and the fourth sensing phase is multiplied, respectively, by -1.

3. The method (30) of claim 1 or 2, wherein the first value (V1) of the voltage is zero, and the second value (V2) and the third value (V3) have the same absolute value but different signs.

4. The method (30) of claim 3, wherein the absolute value of the second value (V2) and the third value (V3) of the voltage is respectively in a range of 0.1-1 V.

5. The method (30) of one of the claims 1 to 4, wherein multiple repetitions (61) of the four sensing phases are performed.

6. The method of claim 5, wherein for two consecutive repetitions (61) of the four sensing phases, the sequence of the four sensing phases is reversed.

7. The method of claim 5 or 6, wherein for two consecutive repetitions (61) of the four sensing phases, for the first repetition (61) the sequence is first, then second, then third, then fourth sensing phase, while for the second repetition (61) the sequence is fourth, then third, then second, then first sensing phase.

8. A ferroelectric memory device (40) comprising
a memory cell including a ferroelectric capacitor (41);
a first voltage line (42) connected to a first capacitor plate of the ferroelectric capacitor (41);
a second voltage line (43) connected to a second capacitor plate of the ferroelectric capacitor (41);
a charge sensor (44) connected to the first voltage line (42) and configured to sense and sum charge on the first voltage line (42);
a voltage source (46) configured to apply a voltage to the ferroelectric capacitor plates of the ferroelectric capacitor (41) via the voltage lines (42, 43), wherein a value of the voltage is always lower than a voltage value required to change a current polarization state of the ferroelectric capacitor (41); and
a memory controller (45);
wherein for reading out the memory cell, the memory controller (45) is configured to control the voltage source (46) and the charge sensor (44), respectively, to:
raise the applied voltage from a first value (V1) to a second value (V2) during a first sensing phase;
lower the applied voltage from the second value (V2) to the first value (V1) during a second sensing phase;
lower the applied voltage from the first value (V1) to a third value (V3) during a third sensing phase;
raise the applied voltage from the third value (V3) to the first value (V1) during a fourth sensing phase;
wherein the first value (V1) is the midpoint between the second value (V2) and the third value (V3); and
sense and sum the charge on the first voltage line (42) during the four sensing phase, wherein the sign of the charge, which is sensed during the second and the fourth sensing phase, respectively, is reversed before the summing.

9. The ferroelectric memory device (40) of claim 8, wherein the first voltage line (42) is a bit line (72), and the second voltage line (43) is a word line (73) or is connected to a word line (73) of the ferroelectric memory device (40).

10. The ferroelectric memory device (40) of claim 8 or 9, comprising:
a plurality of memory cells, wherein each of the memory cells comprises a ferroelectric capacitor (41), and wherein the memory cells are arranged in an array (71) comprising rows and columns;
a plurality of bit lines (72) comprising the first voltage line (42), wherein each of the bit lines (72) is connected to the memory cells of one column:
a plurality of word lines (73) comprising the second voltage line (43), wherein each of the word lines (73) is connected to the memory cells of one row;
wherein each memory cell is connected to one of the bit lines (72) and to one of the word lines (73);
a plurality of charge sensors (44), wherein each bit line (72) is connected to one charge sensor (44);
wherein the memory controller (45) is configured to, in order to read out a particular memory cell of the array (71):
control the voltage source (45) to apply the voltage to the ferroelectric capacitor plates of the ferroelectric capacitor (41) of the particular memory cell, and to change the voltage from the first value (V1) to the second value (V2), then from the second value (V2) to the first value (V1), then from the first value (V1) to the third value (V3), and then from the third value (V3) to the first value (V1) during, respectively, the four sensing phases; and
control the charge sensor (44) associated with the particular memory cell to sense and sum the charge on the bit line (72) connected to the particular memory cell during the four sensing phases, wherein the sign of the charge, which is sensed during the second and the fourth sensing phase, respectively, is reversed before the summing.

11. The ferroelectric memory device (40) of one of the claims 8 to 10, wherein the ferroelectric capacitor (41) comprises a ferroelectric material arranged between the first and the second capacitor plate, and wherein the first and the second capacitor plate are metallic and have the same work function.

12. The ferroelectric memory device (40) of claim 11, wherein the ferroelectric material comprises hafnium-zirconium oxide, HZO, or doped HZO.

13. The ferroelectric memory device (40) of one of the claims 8 to 12, wherein the ferroelectric capacitor (41) comprises a C-V curve that is symmetric around the first value (V1) of the voltage, for instance, around zero voltage.

14. A memory controller (45) for controlling a ferroelectric memory device (40), wherein, in order to control the read out of a memory cell of the ferroelectric memory device (40), the memory controller (45) is configured to perform the method (30) of one of the claims 1 to 7.

15. A computer program comprising instructions which, when the program is executed by the memory controller (45) of claim 14, causes the memory controller (45) to perform the method (30) of one of the claims 1 to 7.
